# EUROPEAN PATENT SPECIFICATION

(11) **EP 0 632 686 B1**
(45) Date of publication and mention of the grant of the patent: **21.08.1996**
(21) Application number: 94850103.6
(22) Date of filing: 14.06.1994
(51) Int. Cl.: H05K 7/20, H05K 9/00

(54) **A device for shielding and/or cooling electronic components**
Vorrichtung zur Schirmung und/oder Kühlung den elektronischen Komponenten
Dispositif de blindage et/ou de réfrigération des éléments électroniques

(30) Priority: 29.06.1993 SE 9302243
(43) Date of publication of application: 04.01.1995
(73) Proprietor: TELEFONAKTIEBOLAGET LM ERICSSON, 126 25 Stockholm (SE)
(72) Inventor: Pettersson, Sven Yngve, S-141 37 Huddinge (SE); Schneider, Georg Adelbert, S-761 75 Norrtälje (SE)
(74) Representative: Lövgren, Tage

(56) References cited:
- EP-A- 0 380 740
- EP-A- 0 465 692
- DE-C- 3 717 009
- US-A- 4 758 924
- US-A- 5 237 486

## Description

### TECHNICAL FIELD

The present invention relates to a device for shielding and/or cooling an electronic component mounted on a printed circuit board or the like; see for example DE-C-3717009.

### BACKGROUND ART

It is often necessary to shield electronic components against ambient electromagnetic radiation, in order to prevent such components being affected by external interference, and in order to prevent, in turn, radiation emitted by such components having a disturbing influence on those parts of the equipment in which said components are fitted. Several different solutions have been proposed to this end. Many electronic components also generate heat when in use, and it is therefore necessary to cool such components to prevent them from being destroyed. Several different solutions have also been proposed to this end. The drawbacks with present-day devices is that they are intended either as a shielding medium or as a cooling medium, so that a device which is effective in shielding such components is not effective in cooling said components, whereas a device which is effective in cooling the components does not screen or shield the components satisfactorily.

### SUMMARY OF THE INVENTION

The object of the present invention is thus to provide a device which will both shield and cool an electronic component in a satisfactory fashion. This object has been achieved with a device as defined in claim 1 which combines component shielding and component cooling in a two-part construction which comprises a metal frame that surrounds the component and a metal cooling plate which fits into the frame and includes cooling fins, wherein a number of resilient contact means create metallic contact between the plate and the frame and, at the same time, press the cooling plate against the electronic component so as to obtain good thermal transmission between the component and the plate. The device has acquired the characteristic features set forth in the following Claims.

The advantage afforded by a device constructed in accordance with the invention is that one single device provides the dual function of shielding and cooling an electronic component. The device also functions equally as well in solely one of these aspects, i.e. is effective in performing solely a shielding or solely a cooling function.

The invention will now be described in more detail with reference to an exemplifying embodiment thereof and also with reference to the accompanying drawings.

### BRIEF DESCRIPTION OF THE DRAWINGS

Figure 1 is a perspective view of one example of an electronic component and parts of the inventive device coacting therewith.

Figure 2 is a perspective view and a sectional view of the device according to Figure 1 fitted over the component.

### BEST MODES OF CARRYING OUT THE INVENTION

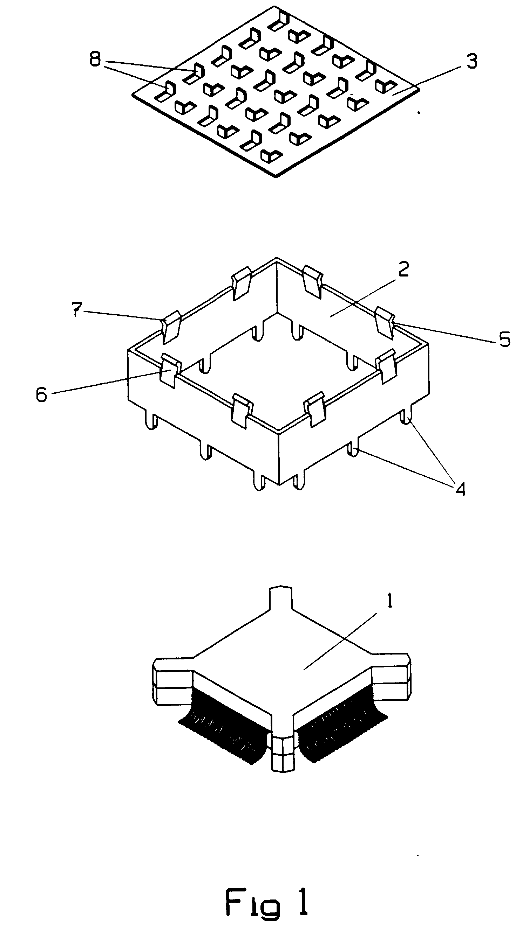

Figure 1 illustrates an electronic component 1 and a metal frame 2 and a metal cooling plate 3 which form parts of an inventive device. In the illustrated case, the electronic component 1 has the form of a multi-pole integrated circuit which emits heat in use, although the component may, of course, be any other heat-emitting component which is intended to be mounted on a circuit board or the like (not shown in the drawings). The size of the metal frame 2 is adapted to the size of the component 1, so as to enable the frame to be mounted on the circuit board while surrounding the component with the sides of the frame spaced slightly therefrom. The height of the frame 2 is adapted so that the frame will extend slightly above the component 1 when mounted on the circuit board, so as to enable the cooling plate 3 to be pressed against the component, as explained in more detail below.

The metal frame 2 is provided along its bottom edges with connecting legs 4 which are intended to be received in corresponding holes in the circuit board or the like. The connecting legs 4 are also intended to connect the frame 2, and thus indirectly also the cooling plate 3, to an earthing surface in the circuit board, so as to connect the shielding device electrically to earth. The sides of the frame 2 are provided along their upper edges with resilient contact means 5, which have the form of tongues 6 clipped in the upper edges of said sides. The tongues 6 extend slightly above the upper edge of the frame and are bent inwardly towards the centre thereof. The outermost part 7 of respective tongues 6 is bent outwardly, as shown in Figure 1, and functions as a guide when the cooling plate 3 is fitted into the frame 2.

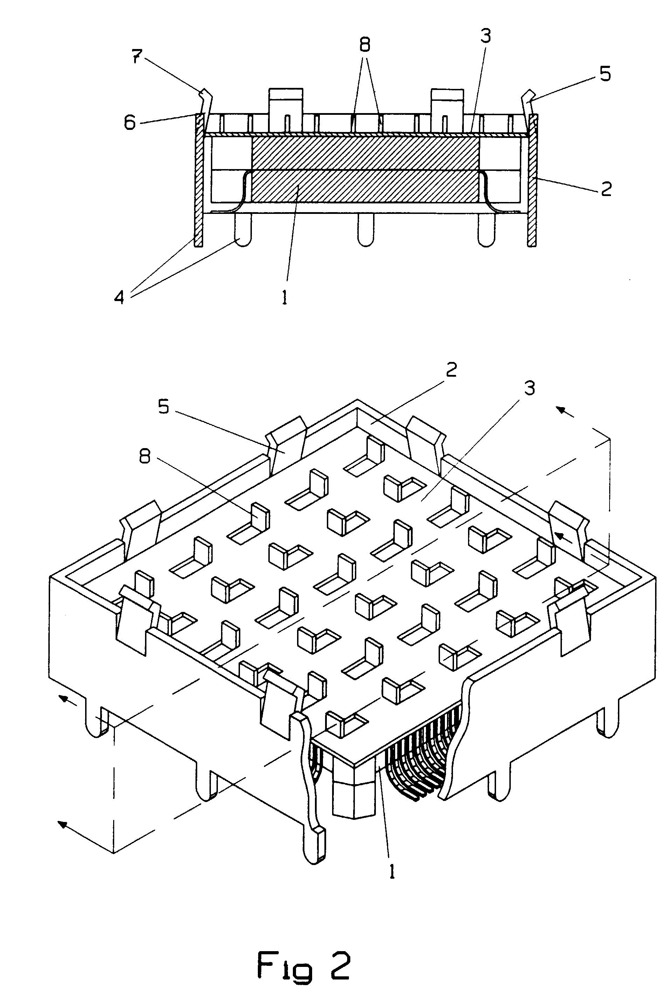

The cooling plate 3 is comprised of a metal plate which is adapted to the size of the frame 2 and from which a number of cooling fins 8 have been clipped and folded upwards at a right angle. When fitting the cooling plate 3, the plate is guided into the frame 2 with the aid of the outermost parts 7 of the tongues 6, wherewith the contact means 5 spring outwards and then return and force the cooling plate 3 into abutment with the component 1 by virtue of the spring action exerted by their inwardly sloping sides, as illustrated in Figure 2. Because the cooling plate 3 fits precisely in the frame 2, and because the contact means 5 create metallic contact between the frame and the cooling plate, the component 1 is fully shielded by the frame and the plate when the plate is mounted in position. Because the cooling plate 3 is pressed against the component 1 by the contact means 5, there is also obtained good thermal transmission between component and cooling plate, and thus satisfactory cooling of the component, this cooling effect being enhanced by the cooling fins 8.

It will be understood that the described and illustrated component shielding and cooling device merely represents an example of the invention, and that both the geometrical configuration and the number of connecting legs and the number of contact means can be varied in accordance with the configuration of the electronic component to be protected. The size and the number of the cooling fins can also be varied as required, and may even be omitted when the inventive device is intended solely to shield the component.

It will also be understood that the invention is not restricted to the aforedescribed and illustrated exemplifying embodiment thereof and that this embodiment can be modified within the scope of the following Claims.

## Claims

1. A device for shielding and/or cooling an electronic component mounted on a circuit board, the device including a metal frame (2) which is mounted on the circuit board so as to surround the electronic component (1), and a metal cooling plate (3) which fits into the frame (2), wherein the frame is provided with resilient contact means (5) along those edges thereof which lie distal to the circuit board, said contact means creating electric contact between the cooling plate (3) and the frame (2) and functioning to press the cooling plate (3) against the component (1) so as to obtain good thermal transmission between the component and the cooling plate.

2. A device according to Claim 1, **characterized** in that the cooling plate (1) is provided with cooling fins (8) on that side thereof which lies distal to the component (1).

3. A device according to Claim 1, **characterized** in that the contact means (5) are comprised of tongues (6) which have been clipped downwardly to some extent in the edges of the frame (2) and which are folded inwards and extend slightly above the upper edge of said frame.

4. A device according to Claim 1, **characterized** in that the outermost parts (7) of the tongues (6) are folded outwards to form cooling plate guides when inserting the cooling plate into the frame.

5. A device according to Claim 1, **characterized** in that the frame (2) is provided with connecting legs (4) for fitting the frame into corresponding holes in the circuit board and for connecting the frame to an earthing surface provided in the circuit board.

## Patentansprüche

1. Vorrichtung zur Schirmung und/oder Kühlung einer auf einer Schaltungsplatte montierten elektronischen Komponente, wobei die Vorrichtung einen Metallrahmen (2) umfaßt, welcher auf der Schaltungsplatte so montiert ist, daß er die elektronische Komponente (1) umgibt, und eine Metallkühlplatte (3), welche in den Rahmen (2). paßt, wobei der Rahmen ausgestattet ist mit elastischen Kontaktvorrichtungen (5) entlang jener seiner Ränder, welche von der Schaltungpslatte abgewendet sind, wobei die Kontaktvorrichtungen einen elektrischen Kontakt erzeugen zwischen der Kühlplatte (3) und dem Rahmen (2) und dazu dienen, die Kühlplatte (3) gegen die Komponente (1) zu drücken, um so eine gute Wärmeübertragung zwischen der Komponente und der Kühlplatte zu erhalten.

2. Vorrichtung nach Anspruch 1, dadurch gekennzeichnet, daß die Kühlplatte (1) ausgestattet ist mit Kühlrippen (8) auf jener ihrer Seiten, welche von der Komponente (1) abgewendet ist.

3. Vorrichtung nach Anspruch 1, dadurch gekennzeichnet, daß die Kontaktvorrichtungen (5) Zungen (6) umfassen, welche nach unten ein Stück weit in die Ränder des Rahmens (2) geschnitten wurden und welche nach innen gefaltet werden und leicht über den oberen Rand des Rahmens stehen.

4. Vorrichtung nach Anspruch 1, dadurch gekennzeichnet, daß die äußersten Teile (7) der Zungen (6) nach außen gefaltet werden, um Kühlplattenführungen zu bilden bei der Einführung der Kühlplatte in den Rahmen.

5. Vorrichtung nach Anspruch 1, dadurch gekennzeichnet, daß der Rahmen (2) ausgestattet ist mit Verbindungsbeinen (4) zur Einpassung des Rahmens in entsprechende Löcher in der Schaltungsplatte und zur Verbindung des Rahmens mit einer in der Schaltungsplatte vorgesehenen Erdungsfläche.

## Revendications

1. Dispositif pour le blindage et/ou le refroidissement d'un composant électronique monté sur une plaquette à circuit ou analogue, caractérisé en ce que le dispositif comporte un bâti métallique (2) qui est monté sur la plaquette à circuit de façon à entourer le composant électronique (1), et une plaque métallique (3) de refroidissement qui s'ajuste dans le bâti (2), le bâti étant pourvu de moyens élastiques (5) de contact le long de ses bords qui s'étendent du côté distal par rapport à la plaquette à circuit, lesdits moyens de contact établissant un contact électrique entre la plaque (3) de refroidissement et le bâti (2) et fonctionnant de façon à presser la plaque (3) de refroidissement contre le composant (1) pour que l'on obtienne une bonne transmission de la chaleur entre le composant et la plaque de refroidissement.

2. Dispositif selon la revendication 1, caractérisé en ce que la plaque (1) de refroidissement est pourvue d'ailettes (8) de refroidissement sur son côté qui s'étend du côté distal par rapport au composant (1).

3. Dispositif selon la revendication 1, caractérisé en ce que les moyens (5) de contact sont constitués de languettes (6) qui ont été découpées vers le bas sur une certaine étendue dans les bords du bâti (2) et qui sont pliées vers l'intérieur et s'étendent légèrement au-dessus du bord supérieur dudit bâti.

4. Dispositif selon la revendication 1, caractérisé en ce que les parties (7) situées le plus à l'extérieur des languettes (6) sont pliées vers l'extérieur pour former des guides pour la plaque de refroidissement lors de l'insertion de la plaque de refroidissement dans le bâti.

5. Dispositif selon la revendication 1, caractérisé en ce que le bâti (2) est pourvu de pattes (4) de connexion pour le montage du bâti dans des trous correspondant de la plaquette à circuit et pour la connexion du bâti à une surface de mise à la terre prévue dans la plaquette à circuit.
